# EUROPEAN PATENT SPECIFICATION

(11) **EP 1 158 574 B1**
(45) Date of publication and mention of the grant of the patent: **21.07.2010**
(21) Application number: 99973676.2
(22) Date of filing: 07.10.1999
(51) Int. Cl.: H01L 21/304, H01L 21/3065, G21K 5/00

(54) **ULTRAVIOLET RADIATION PRODUCING APPARATUS**
GERÄT ZUR ERZEUGUNG VON ULTRAVIOLETTER STRAHLUNG
APPAREIL EMETTEUR DE RAYONNEMENT ULTRAVIOLET

(43) Date of publication of application: 28.11.2001
(73) Proprietor: USHIO DENKI KABUSHIKI KAISYA, Tokyo, 100-0004 (JP)
(72) Inventor: HISHINUMA, Nobuyuki, Himeji-shi, Hyogo 670-0893 (JP); SUGAWARA, Hiroshi, Himeji-shi, Hyogo 672-8083 (JP); TAKEMOTO, Fumitoshi, Himeji-shi, Hyogo 670-0092 (JP); TOKAI, Hiroaki, Himeji-shi, Hyogo 671-0231 (JP); MURASE, Jun, Hyogo-ken (JP)
(74) Representative: Tomerius, Isabel
(86) International application number: PCT/JP1999/005542
(87) International publication number: WO 2001/027984

(56) References cited:
- JP-A- 1 074 717
- JP-A- 9 027 468
- JP-A- 9 074 079
- JP-A- 9 260 303
- JP-A- 11 295 500
- JP-A- 61 234 532
- US-A- 4 837 484
- US-A- 5 217 559

## Description

### Field of Technology

This invention concerns ultraviolet illumination equipment to perform dry washing by means of ultraviolet radiation from a dielectric-barrier discharge lamp, and by means of ozone created at the same time by the ultraviolet radiation.

### Background of Technology

Technology for dry washing by means of ultraviolet illumination equipment using an ultraviolet radiation light source has been known for some time; this ultraviolet illumination equipment has been used for light ashing and precision light washing in the liquid crystal and semiconductor field.

Ultraviolet illumination equipment of this type have previously used, as the ultraviolet light source, low-pressure mercury lamps and medium pressure mercury lamps that radiate well at the ultraviolet wavelengths of 253.7 nm or 184.9 nm.

Various chemicals such as organic solvents, acids and alkalis are used when processing semiconductor or liquid crystal devices, and so these chemicals are often removed by evaporation. Among these chemicals are those that absorb ultraviolet radiation and are broken down by the energy and produce reaction products after reacting with other chemicals. For example, ammonium bisulfate (NH₄)H(SO₄)₂ and ammonium sulfate (NH₄)₂SO₄ are produced. JP 09 027 468 A discloses (Figure 4) a dry washing apparatus comprising a plurality of heaters and a plurality of UV lamps 7.

Such reaction products circulate as fine dust particles within the clean room, and when these fine dust particles accumulate, they sometimes become a factor with a deleterious effect on the manufacturing process.

On the other hand, in recent years, dielectric-barrier discharge lamps with high energy, a single wavelength and good efficiency have come to be used, in place of the mercury lamps described above, as the ultraviolet light source in ultraviolet illumination equipment.

In ultraviolet illumination equipment that uses a dielectric-barrier discharge lamp as the ultraviolet light source, the dielectric-barrier discharge lamp is placed in a receptacle that is sealed to separate it from the atmosphere, and the ultraviolet radiation emitted by the dielectric-barrier discharge lamp passes through a part of that receptacle to illuminate the item to be processed.

JP 09 074 079 A discloses (Figure 1) a dry washing apparatus comprising a plurality of dielectric-barrier discharge lamps 7. In JP 09 074 079 A, the receptable 21 is provided with a gas flow.

Nevertheless, there has been a problem in that ultraviolet illumination equipment that uses a dielectric-barrier discharge lamp has a window through which the ultraviolet radiation passes, and the reaction products mentioned above are carried by convection and adhere to this window.

The reason the reaction products adhere to the window is that when the dielectric-barrier discharge lamp is lit, the temperature of the front of the lamp is low, about 70°C, and so the radiant heat radiated from the lamp cannot heat the window sufficiently. Because of that, reaction products that come into contact with the window are not carried away from the window by the radiant heat, but immediately adhere to the window.

As a result, there are the problems that the transparency to ultraviolet radiation is lowered by the reaction products that adhere to the window, and the intensity of the ultraviolet radiation is not uniform throughout the area of illumination.

There is the further problem that processing defects and flaws appear on the item being processed, and the yield is reduced.

In cases of a considerable buildup of reaction products adhered to the window, there is a problem in that the reaction products can peel off the window as large pieces of debris, and contaminate the processing environment of the clean room. This invention was made on the basis of the situation described above; its purpose is to provide ultraviolet illumination equipment that makes it possible to prevent reaction products due to ultraviolet radiation from adhering to the window, and thus to prevent reduction of the intensity of the ultraviolet radiation and the formation of debris from the reaction products.

### Presentation of Invention

In order to resolve the problems described above, the ultraviolet illumination equipment described in claim 1 is ultraviolet illumination equipment that has a dielectric-barrier discharge lamp located within a sealed receptacle with a gas whose transparency is inactive with regard to the light emitted by the dielectric-barrier discharge lamp, and a window in the receptacle through which the ultraviolet radiation from the dielectric-barrier discharge lamp is emitted, and wherein a heating means to heat the window to at least 100°C is formed directly on the surface of the dielectric-barrier discharge lamp side of the window.

The ultraviolet illumination equipment described in claim 2 is ultraviolet illumination equipment as described in claim 1 above, in which the heating means is a thick-film heater formed on the surface of the window.

The ultraviolet illumination equipment described in claim 3 is ultraviolet illumination equipment as described in claim 1 above, in which the heating means is a linear heater formed on the surface of the window.

### Brief Explanation of Drawings

Figure 1 is an explanatory drawing of the ultraviolet illumination equipment of this invention.
Figure 2 is an explanatory drawing of a window using a thick-film heater as the heating means.
Figure 3 is an explanatory drawing of a window using a microheater as the heating means.
Figure 4 is an explanatory drawing of a window usable with the invention and using incandescent bulbs as the heating means.
Figure 5 is experimental data showing the change, due to the temperature of the window, in transparency to ultraviolet radiation caused by the adherence of radiation products.

### Optimum Effect of Implementation of Invention

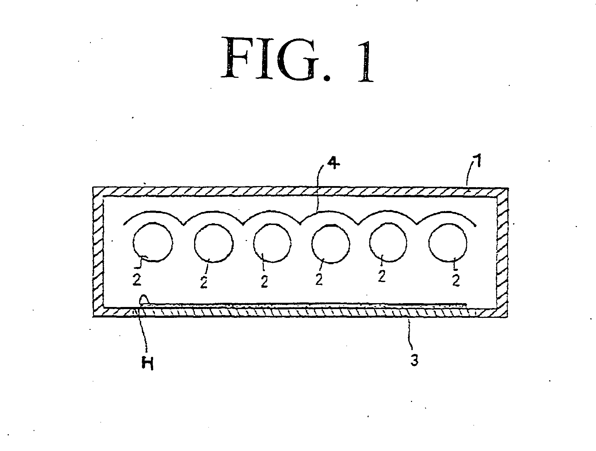

Figure 1 is an explanatory drawing of the ultraviolet illumination equipment of this invention.

Within a receptacle 1 made of stainless steel, there are a number of dielectric-barrier discharge lamps 2 that emit ultraviolet radiation. There is a window 3 made of quartz glass to be transparent to ultraviolet radiation on the front of the receptacle 1.

On the inner surface of the window 3 of the ultraviolet illumination equipment is formed a heating means H to heat the window 3 to at least 100°C. Now, the heating means H will be explained in detail hereafter.

The receptacle 1 is sealed closed, and the dielectric-barrier discharge lamps 2 are separated from the atmosphere. The receptacle 1 is sealed with a gas, such as nitrogen, argon or neon, whose transparency is inactive with regard to the light emitted by the dielectric-barrier discharge lamps 2.

The dielectric-barrier discharge lamps w are filled with xenon at 250 Torr as a discharge gas. The input power is 0.2 W per square centimeter of sight emitting area, and ultraviolet radiation with a maximum wavelength of 172 nm is emitted efficiently.

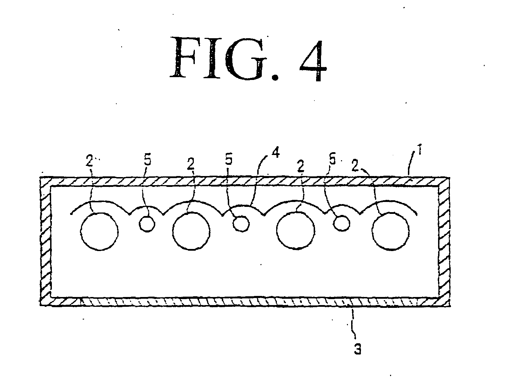

In figure 1, 4 is a reflecting mirror that efficiently reflects the ultraviolet radiation emitted by the dielectric-barrier discharge lamps 2 toward the window.

The heating means is explained next.

### <Heating means 1 >

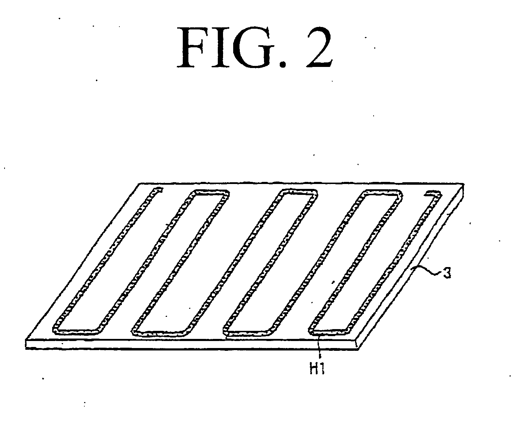

As shown in figure 2, a thick-film heater is formed within the ultraviolet illumination equipment, and specifically on the surface of the dielectric-barrier discharge lamp side of the window 3.

This thick-film heater H1 is a conductive, heat-generating paste that is screen printed onto the window 3, then baked for 30 minutes at 500°C.

Now, the amount of heat produced by this thick-film heater H2 is 1.9 kW.

### <Heating means 2>

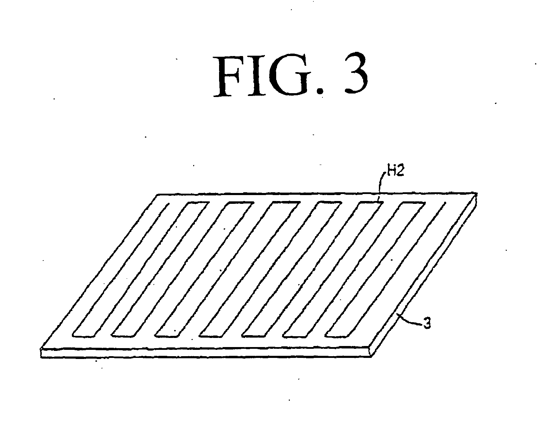

As shown in figure 3, a microheater, which is a linear heater, is formed within the ultraviolet illumination equipment, and specifically on the surface of the dielectric-barrier discharge lamp side of the window 3.

This microheater is a fine tube of stainless steel with a nicrome wire running along the center of the tube as a heating element, the space between the tube and the wire being filled with high-grade powdered magnesium. It is a bendable heater.

Now, this microheater is 1.6 mm in diameter and 40 m in length; the amount of heat produced is 4kW.

The reason that these heating means, the thick-film heater and the linear heater, are formed within the ultraviolet illumination equipment, and specifically on the surface of the dielectric-barrier discharge lamp side of the window 3 is this: to prevent deterioration of the heaters by preventing direct contact of the heaters with the gases and vapors produced during processing of the item being processed, and to keep the heaters from casting a shadow on points directly below the heaters.

Moreover, by forming the thick-film heater and the linear heater directly on the surface of the window 3, it is possible to heat the window 3 more efficiently.

### <Heating means 3 (usable with the invention)>

As shown in figure 4, incandescent halogen bulbs 5 are placed between the dielectric-barrier discharge lamps 2, within the receptacle 1.

In this case, the window 3 is heated by the infrared radiation from the incandescent bulbs.

When incandescent bulbs are used as the heating means in this way, the structure of the ultraviolet illumination equipment is simpler than with thick-film heaters or linear heaters, and there is no obstruction at all of ultraviolet radiation passing through the window. Therefore, the uniformity of intensity of the ultraviolet radiation emitted is even better.

Now in this implementation, the incandescent bulbs were 500 W, 25 A halogen lamps sealed on both ends.

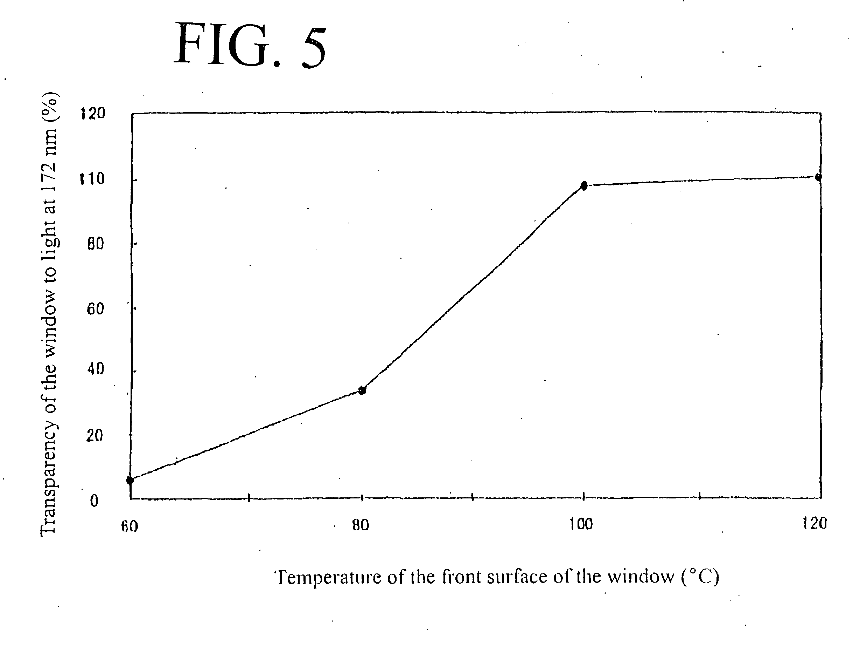

Next, experimentation was done to investigate the amount of adhered material relative to the temperature of the window, using the ultraviolet illumination equipment shown in figure 1 with a thick-film heater on the window, as shown in figure 2. The results are shown in figure 5.

In figure 5, the vertical scale shows the window's transparency to light with a wavelength of 172 nm. As the temperature of the window rose, the transparency increased. From that fact is was known that as the temperature of the window became higher, the reaction products which had adhered to the window began to break up and separate from the window. When the window was at 100°C, reaction products that even approached the window were broken up by its radiant heat, and none adhered to the window.

As was learned from these results, heating the window to at least 100°C made it possible to prevent the reaction products from adhering to the window, to prevent a reduction in the intensity of ultraviolet radiation, and to prevent the formation of debris from reaction products.

As explained above, the ultraviolet illumination equipment of this invention uses a heating means to heat the window to at least 100°C, and so it is possible to prevent the reaction products of organic solvents, acids, alkalis or other chemicals, due to ultraviolet radiation, from adhering to the window, and it is possible to prevent the formation of debris from the reaction products.

Moreover, because the heating means is established within the ultraviolet illumination equipment, it does not undergo deterioration from contact with organic solvents, acids, alkalis or other chemicals.

Because the thick-film heaters and linear heaters used as heating means are formed directly on the surface of the window, the heat generated by these heaters heats the window directly, and so it is possible to heat the window efficiently.

Using incandescent bulbs as the heating means simplifies manufacturing and further improves the uniformity of ultraviolet radiation intensity, in addition to heating the window.

### Field of Industrial Use

This invention can be used as ultraviolet illumination equipment for dry washing by means of the ultraviolet radiation emitted by the dielectric-barrier discharge lamp and simultaneously by means of the ozone produced by that ultraviolet radiation.

## Claims

1. Ultraviolet illumination equipment that has a dielectric-barrier discharge lamp (2) located within a sealed receptacle (1) with a gas whose transparency is inactive with regard to the light emitted by the dielectric-barrier discharge lamp (2), and a window (3) in the receptacle through which the ultraviolet radiation from the dielectric-barrier discharge lamp (2) is emitted, and wherein a heating means (H) to heat the window to at least 100°C is formed directly on the surface of the dielectric-barrier discharge lamp (2) side of the window (3).

2. Ultraviolet illumination equipment as described in claim 1 above, in which the heating means (3) is a thick-film heater formed on the surface of the window (3).

3. Ultraviolet illumination equipment as described in claim 1 above, in which the heating means (3) is a linear heater formed on the surface of the window (3).

## Patentansprüche

1. Ultraviolett-Beleuchtungsausrüstung, die eine dielektrisch behinderte Entladungslampe (2) aufweist, welche in einem abgedichteten Behälter (1) mit einem Gas angeordnet ist, dessen Transparenz mit Bezug auf das von der dielektrisch behinderten Entladungslampe (2) abgegebene Licht inaktiv ist, und ein Fenster (3) in dem Behälter aufweist, durch das die Ultraviolettstrahlung von der dielektrisch behinderten Entladungslampe (2) abgegeben wird, und wobei ein Heizmittel (H) zum Erhitzen des Fensters auf mindestens 100°C unmittelbar auf der Oberfläche der Seite der dielektrisch behinderten Entladungslampe (2) des Fensters (3) gebildet ist.

2. Ultraviolett-Beleuchtungsausrüstung gemäß Anspruch 1, in der das Heizmittel (3) ein Dickschichtheizelement ist, das auf der Oberfläche des Fensters (3) ausgebildet ist.

3. Ultraviolett-Beleuchtungsausrüstung gemäß Anspruch 1, in der das Heizmittel (3) ein lineares Heizelement ist, das auf der Oberfläche des Fensters (3) ausgebildet ist.

## Revendications

1. Équipement d'éclairage ultraviolet comprenant une lampe à décharge à barrière diélectrique (2) située dans un réceptacle (1) fermé hermétiquement avec un gaz dont la transparence est inactive par rapport à la lumière émise par la lampe à décharge à barrière diélectrique (2), et une fenêtre (3) dans le réceptacle à travers laquelle le rayonnement ultraviolet de la lampe à décharge à barrière diélectrique (2) est émis, et dans lequel un moyen de chauffage (H) pour chauffer la fenêtre à au moins 100°C est formé directement sur la surface du côté de la fenêtre (3) situé vers la lampe à décharge à barrière diélectrique (2).

2. Équipement d'éclairage ultraviolet selon la revendication 1, dans lequel le moyen de chauffage (3) est un élément chauffant en film épais formé sur la surface de la fenêtre (3).

3. Équipement d'éclairage ultraviolet selon la revendication 1, dans lequel le moyen de chauffage (3) est un élément chauffant linéaire formé sur la surface de la fenêtre (3).
